# EUROPEAN PATENT SPECIFICATION

(11) **EP 4 500 660 B1**
(45) Date of publication and mention of the grant of the patent: **02.12.2026**
(21) Application number: 23775764.6
(22) Date of filing: 27.03.2023
(51) Int. Cl.: G06F 1/20, G06F 1/26, H02J 9/06

(54) **UNINTERRUPTIBLE POWER SUPPLY WITH INTEGRATED MAINTENANCE BYPASS CABINET ALLOWING REDUCED U-HEIGHT AND INCREASED AIRFLOW**
UNTERBRECHUNGSFREIE STROMVERSORGUNG MIT INTEGRIERTEM WARTUNGSBYPASSSCHRANK MIT REDUZIERTER U-HÖHE UND ERHÖHTEM LUFTSTROM
ALIMENTATION SANS INTERRUPTION AVEC ARMOIRE DE DÉRIVATION DE MAINTENANCE INTÉGRÉE PERMETTANT UNE HAUTEUR U RÉDUITE ET UN FLUX D'AIR ACCRU

(30) Priority: 25.03.2022 US 202263323627 P
(43) Date of publication of application: 05.02.2025
(73) Proprietor: Vertiv Corporation, Westerville, OH 43082 (US)
(72) Inventor: HOCKENSMITH, Brian, Columbus, OH 43235 (US); GONZALEZ, Eric, Manville, RI 02838 (US); SCARCI, Joseph, Mcmurray, PA 15317 (US)
(74) Representative: Bryn-Jacobsen, Caelia
(86) International application number: PCT/US2023/016423
(87) International publication number: WO 2023/183650

(56) References cited:
- WO-A1-2020/146464
- US-A1- 2007 114 851
- US-A1- 2016 226 301
- US-A1- 2019 064 898
- US-A1- 2019 165 552
- US-A1- 2022 087 041

## Description

### CROSS REFERENCE TO RELATED APPLICATIONS

The present application claims the benefit of U.S. Provisional Patent Application Serial Number 63/323,627 filed March 25, 2022.

### TECHNICAL FIELD

The present disclosure relates generally to uninterruptible power supplies, and more particularly to uninterruptible power supplies configured with bypass switches.

### BACKGROUND

Uninterruptible power supplies (UPS) are used to provide constant and stable power to electrical devices and are particularly used in computer server and networking systems. A UPS that is installed in a computer server and networking racks is preferably used in conjunction with a maintenance bypass switch, also referred to as a maintenance bypass cabinet (MBC), that serves to bypass the UPS during UPS-related maintenance while still maintaining utility power to the UPS-associated devices (e.g., servers). Typical MBC designs are discrete and optional addon units that ship separately from the UPS and require additional rack space. Further, placement of the MBC within the rack may not interfere with adequate ventilation of the UPS to prevent the UPS from overheating.
Accordingly, it may be advantageous for a UPS and/or MBS design to remedy the shortcomings of the conventional approaches identified above.

US 2019/064898 A1 in the abstract states:
"An uninterruptible power supply (UPS) system includes a UPS unit having one or more power connectors and control signal connectors. The UPS system further includes a frame configured to removably engage and receive the UPS unit, and a bypass unit positioned within the frame and coupled to a power input and output.
The bypass unit has corresponding power and control signal connectors configured to mate with respective UPS power and control signal connectors responsive to the positioning of the UPS within the frame. The bypass unit further includes a bypass switch controllable between open and closed states, which may be a normally closed relay. When the bypass switch is closed, the bypass branch shunts power around the UPS without decoupling the input from the output. A controller positioned within or outside the UPS controls the bypass switch via one or more control signal lines.".

US 2022/087041 A1 in the abstract states:
"The utility model provides a tower UPS frame and a tower UPS. The tower UPS frame comprises: a power supply module frame, which comprises two ports disposed oppositely; a power supply distribution frame; and a fan assembly, which comprises a fan frame and a fan fixed on the fan frame, wherein the power supply distribution frame and the fan frame are arranged in a same row as the power supply module frame and are detachably connected with the two ports of the power supply module frame. The tower UPS frame of the utility model is convenient in assembly and disassembly and reduces repair cost.".

US 2016/226301 A1 in the abstract states:
"Provided is an uninterruptible power supply apparatus that can properly adjust the capacity of cooling a heat radiation source. A housing for housing an uninterruptible power module is provided with a cooling fan for cooling the internal space of the housing. The housing is further formed with an opening. The opening formed in one housing and the opening formed in an adjacent housing for housing another uninterruptible power module are configured to face each other. Furthermore, each uninterruptible power module includes a fan control circuit for controlling the cooling fan. The fan control circuit controls the actuation and suspension of the cooling fan on the basis of a total load of the plurality of uninterruptible power modules.".

WO 2020/146464 A1 in the abstract states:
"A water heater can include a housing and a heating system disposed within the housing, where the heating system is configured to heat a fluid. The water heater can also include a switch coupled to the heating system, where the switch operates between a first position during normal operations and a second position during an outage. The water heater can further include a primary power source coupled to the switch, where the primary power source is configured to provide primary power to the heating system through the switch during the normal operations. The water heater can also include an uninterruptible power supply (UPS) coupled to the switch, where the UPS is configured to provide reserve power to the heating system through the switch during the outage, and where the UPS is integrated with the housing.".

US 2007/114851 A1 in the abstract states:
"Disclosed is an uninterruptible power supply including a switch connected between an external power source and a load, a power supply module connected to the external power source and the switch for receiving and converting an input power and supplying converted power to the load, a battery module connected to the power supply module for storing electric power or supplying electric power to the power supply module, a control module connected to the external power source and the battery module and powered by the external power source or the battery module for generating a control signal according to a specific operating status of the power supply module to manipulate the switch so as to supply power to the load through the power supply module or a bypass route, and a display panel connected to and powered through the control module for receiving and displaying system status information from the control module.".

US 2019/165552 A1 in the abstract states:
"An uninterruptible power supply includes an input switch, an input filter, and a power converter disposed in this order, an output filter and an output switch disposed in this order from the power converter, and a plurality of conductors that connects the input switch, the input filter, the power converter, the output filter, and the output switch to each other in this order.".

### SUMMARY

Aspects of the present disclosure are set out in the independent claim(s). Other aspects and features of the present disclosure are set out in the claims and the description below.

Accordingly, the present disclosure is directed to an uninterruptible power supply (UPS) couplable to a load and configured to power the load and configured to switch input electrical power between a main power supply and a backup power supply. The present disclosure is also directed to a maintenance bypass cabinet (MBC) couplable to the UPS and configured to switch electrical power between the UPS and a load. The UPS permits power to the load to remain uninterrupted if the main power supply fails. The MBC permits power to the load to remain uninterrupted if the UPS fails or is removed. The MBC may include a cantilevered housing having an end that is mechanically and electrically couplable to an interface surface of the UPS and within the same U space as the UPS. The cantilevered housing of the MPC further includes a cantilever portion that creates open space between a bypass connection panel attached to the cantilever housing and the interface surface of the UPS. The open space increases the ability of air vents along the interface surface of the UPS to circulate air. The interface surface of the UPS may also be configured in a non-flat arrangement, having a recessed and a non-recessed surface that increases the volume of the open space. The interface surface of the UPS may also include two or more air vents that are aligned at different planes.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The numerous advantages of the disclosure may be better understood by those skilled in the art by reference to the accompanying figures.
FIG. 1 is a block diagram illustrating an electrical power system that includes an uninterruptible power supply (UPS), in accordance with one or more examples of the present disclosure.
FIG. 2A is a block diagram illustrating an electrical power system that includes an uninterruptible power supply (UPS) and a maintenance bypass cabinet (MBC), in accordance with one or more examples of the present disclosure.
FIG. 2B is another block diagram illustrating an electrical power system that includes an uninterruptible power supply (UPS) and a maintenance bypass cabinet (MBC), in accordance with one or more examples of the present disclosure.
FIG. 3A is a block diagram of an uninterruptible power supply (UPS) coupled with a maintenance bypass cabinet (MBC), in accordance with one or more examples of the present disclosure.
FIG. 3B is a perspective view of an uninterruptible power supply (UPS), in accordance with one or more examples of the present disclosure.
FIG. 4A is a diagram illustrating the maintenance bypass cabinet (MBC) in a near-coupled position with the uninterruptible power supply (UPS), in accordance with one or more examples of the present disclosure.
FIG. 4B is a diagram illustrating the maintenance bypass cabinet (MBC) coupled with the uninterruptible power supply (UPS), in accordance with one or more examples of the present disclosure.
FIG. 5 is a diagram illustrating the maintenance bypass cabinet (MBC) coupled with the uninterruptible power supply (UPS) including predicted air flow patterns, in accordance with one or more examples of the present disclosure.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

As used herein a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein any reference to "one example" or "examples" means that a particular element, feature, structure, or characteristic described in connection with the example is included in at least one example disclosed herein. The appearances of the phrase "in examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

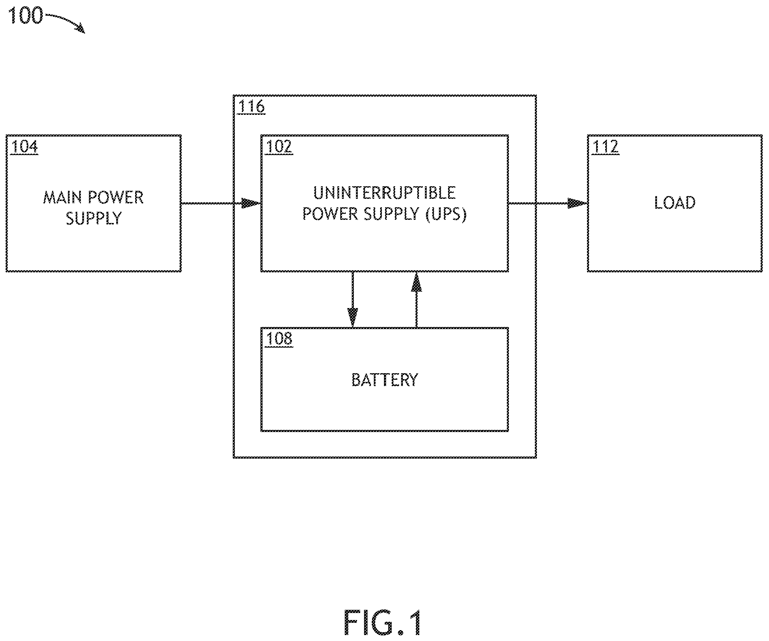

Referring to FIG. 1, a block diagram illustrating an electrical power system 100 that includes an uninterruptible power supply (UPS) 102 in accordance with one or more examples of the disclosure is shown. The electrical power system 100 may include UPS 102, whereby the UPS 102 may be electrically coupled to a main power supply 104 (e.g., utility power), a battery 108, and a load 112. The load 112 may be any electrical device powered by the UPS 102 including but not limited to computer servers. Under normal conditions, the UPS 102 transfers power from the main power supply 104 to the load 112 and monitors characteristics of the transferred power (e.g., voltage and current) to ensure that the load 112 is competently receiving power. If a fault is detected by the UPS, such as a loss of power, or a power surge, the UPS then draws power from the battery 108, which temporarily powers the load 112 until the power from the main power supply 104 is reestablished. In this manner, the UPS 102 provides uninterruptible power to the load 112. The UPS 102 may also charge the battery 108 using power from the main power supply 104. The UPS 102, along with the battery 108, may comprise a UPS system 116. However, the UPS system 116 may also include only the UPS 102. The UPS 102 may also include an internal battery 108.

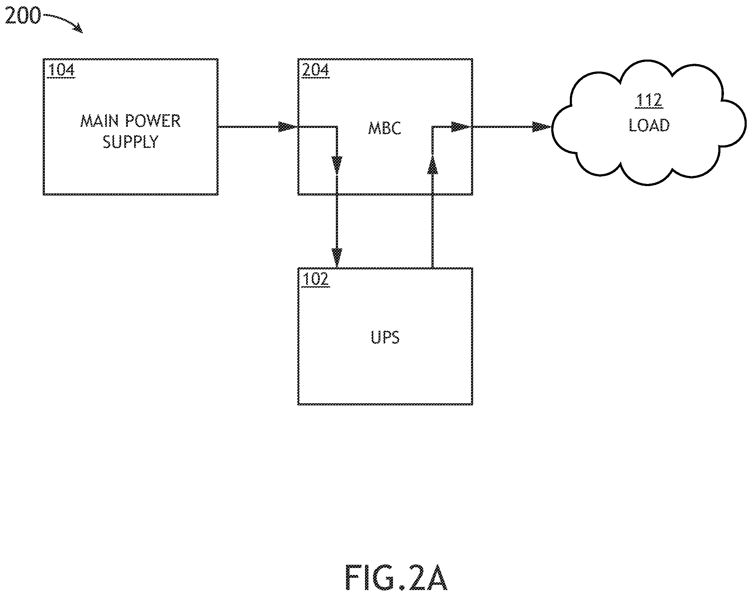

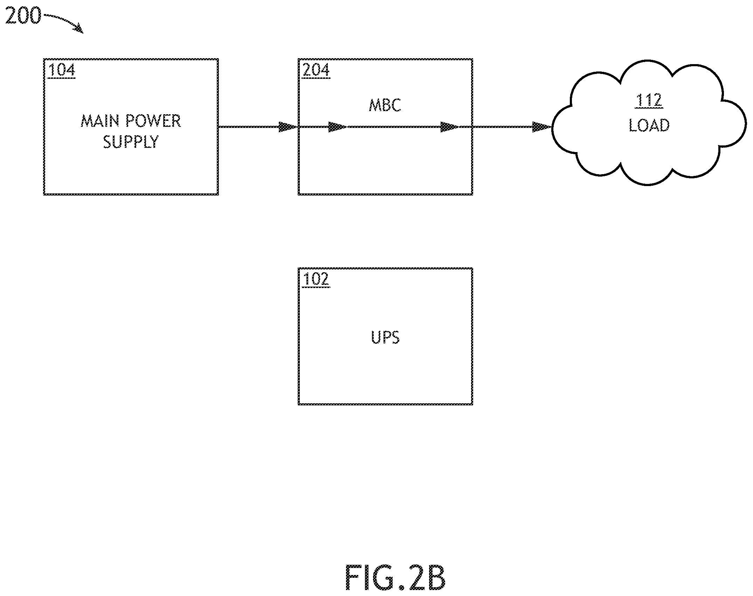

Referring to FIG. 2A, a block diagram illustrating an electrical power system 200 that includes an uninterruptible power supply (UPS) 102 and a maintenance bypass cabinet (MBC) 204, in accordance with one or more examples of the present disclosure is shown. The MBC 204 may provide additional connectivity in powering the load 112, allowing the UPS 102 to be removed for repair or replacement without interruption of power to the load 112. The MBC 204 receives power directly from the main power supply 104 and directs the power to the UPS 102 when the UPS 102 is operable, as shown in FIG. 2A. Power is then provided back to the MBC 204 from the UPS 102, where it connects to, and provides power to, the load 112. When the UPS 102 is not in use (e.g., during times of repair), the MBC 204 performs a switching action, directing power from the main power supply 104 to the load 112 without engaging the UPS 102, as shown in FIG. 2B. In some examples, the UPS system 116 further includes the MBC 204.

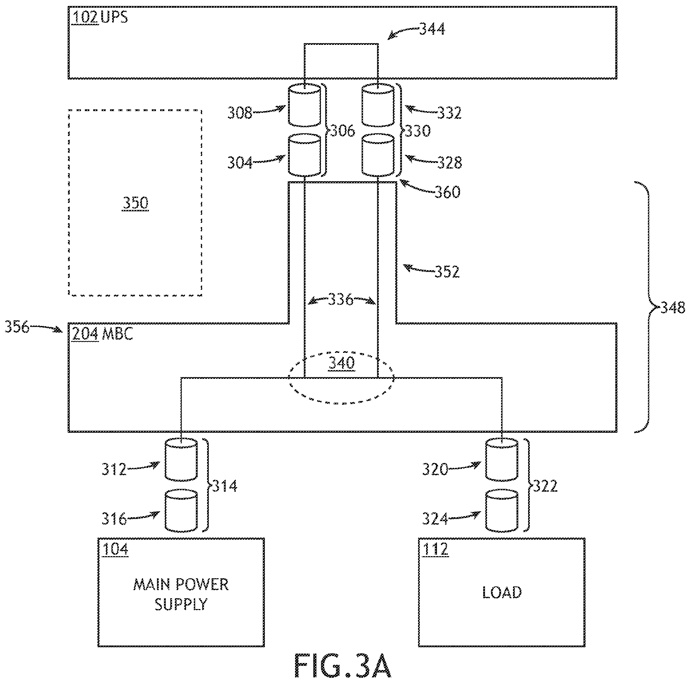

Referring to FIG. 3A, a block diagram of an uninterruptible power supply (UPS) 102 coupled with a maintenance bypass cabinet (MBC) 204, in accordance with one or more examples of the present disclosure is shown. The ability of the MBC 204 to perform switching from the UPS 102 to the load 112 (as shown in FIGS. 2A and 2B) requires several electrical couplings. The electrical couplings are formed by electrical connectors (e.g., plugs, prongs, outlets, receptacles, or wire ends) that form connector pairs in connecting electronic componentry to the MBC 204. Therefore, each electrical connector may be a plug, prong, or wire end that physically couples to a complementary electrical connector. For example, the MBC 204 includes a first electrical connector 304 of a first connector pair 306 that connects to a complementary second electrical connector 308 disposed on the UPS 102. The MBC 204 further includes a first electrical connector 312 of a second connector pair 314 that connects to a complementary second electrical connector 316 of the main power supply 104. The MBC 204 further includes a first electrical connector 320 of a third connector pair 322 that connects to a complementary second electrical connector 324 of the load 112. The MBC 204 further includes a first electrical connector 328 of a fourth connector pair 330 that connects to a complementary second electrical connector 332 disposed on the UPS 102. The MBC 204 may include more than one of the electrical connectors as described above. For example, the MBC may include four, eight, or more first electrical connectors 320 of the third connector pair 322 (e.g., to connect to multiple loads 112).

The MBC 204 may include internal circuitry 336 connecting the various electrical components as well as a switch 340 that determines the routing of electricity through the MBC 204. For example, when the UPS 102 is operable, the switch 340 may be switched to a configuration so that electric current flows from the main power supply 104 through the UPS (via a loop 344) and back through to the load 112. In another example, if the UPS is removed, the switch 340 may be switched to a configuration so that electric current flows from the main power supply 104 directly to the load 112, bypassing the loop 344. The switch 340 may be configured as a manual switch, automated switch, or a hybrid manual/automated switch. For example, the switch 340 may include a physical switch component actuated by a user, which then activates an automated switch component that performs the switch change at an appropriate time (e.g., to minimize phase disruptions, or to time the switch event at a zero-crossing). The internal circuitry 336 may contain any number of electronic components (e.g., resistors, capacitors) and electronic devices (e.g., controllers, processors, memory) as required to perform the functions of the MBC 204.

The MBC 204 may include a cantilevered housing 348 that may impose one or more open spaces 350 between the MBC 204 and the UPS 102. The cantilevered housing 348 may create the one or more open spaces 350 with a dimension (i.e., a length or depth) selected to position a portion of the cantilever housing 348 away from the UPS 102 in order to provide a gap between the UPS 102 and the MBC 204 such that a sufficient thermal exhaust may be provided from the UPS 102 in order to prevent overheating of the UPS 102. It is contemplated that the height of the MBC 204 should be the same or less than the height of the UPS 102, and within the same U space as the UPS 102. It is further contemplated that the depth of open space 350 should be minimized so that the unit can be installed in standard IT racks with depths in the range of 900-1200mm while providing enough open space 350 to allow adequate airflow out of the UPS to keep it from overheating. It is contemplated that the width of the MBC may also impact the requirements of the open space, as a shorter width of the MBC may allow more airflow from the front of the UPS 102 to the back of the UPS 102 and subsequently out of the rack. In one example, the open space 350 may provide sufficient thermal exhaust out of the UPS and may be at least two centimeters between the UPS 102 and the MBC 204. In another example, the open space 350 may provide sufficient thermal exhaust out of the UPS and may be at least three centimeters between the UPS 102 and the MBC 204. In yet another further example, the open space 350 may provide sufficient thermal exhaust out of the UPS and may be three to eleven centimeters between the UPS 102 and the MBC 204.

The open space 350 increases air circulation between the MBC 204 and the UPS 102, preventing the UPS 102 from overheating. The cantilevered housing 348 includes a cantilever portion 352 which is mechanically coupled to a bypass connection panel 356. The cantilever portion 352 includes an end 360 that may be in proximity to the UPS, and may be couplable (e.g., fixable) to the UPS 102. The first electrical connector 304 of the first connector pair 306 and/or the first electrical connector 328 of the fourth connector pair 330 may be disposed on the end 360. In this manner, when the cantilever portion 352 is physically coupled to the UPS 102, the MBC 204 may also be electrically coupled to the UPS 102. Upon the coupling of the cantilever portion 352 to the UPS 102, the open spaces 350 are realized. The coupling between the cantilever portion 352 and the UPS 102 may be performed via any type of coupling technology including but not limited to nut-and-bolt connectors, interference fit connectors, internally threaded rod couplings, and snap-fit connectors.

The MBC 204 may include a cantilevered housing which may be configured as having a "T" shape, as demonstrated in FIG. 3A, and within the same U space as the UPS. However, the MBC 204 may be configured as any type of shape as long as the ability of the MBC 204 to create open spaces is maintained, which is dependent on the cantilever portion 352 and further is within the same U space as the UPS 102. For example, the MBC 204 may be configured as an "L" shape or a cruciform shape, with one of the branches of the "L" shape or the cruciform shape configured as the cantilever portion. In another example, the MBC 204 may be configured as an "I" shape, where the entire MBC 204 is configured as a cantilever portion 352, with the bypass connection panel 356, containing the one or more first electrical connectors 312, 320 incorporated into the cantilever portion 352. Therefore, the description herein should be considered not as a limitation of the MBC 204, but as an illustration.

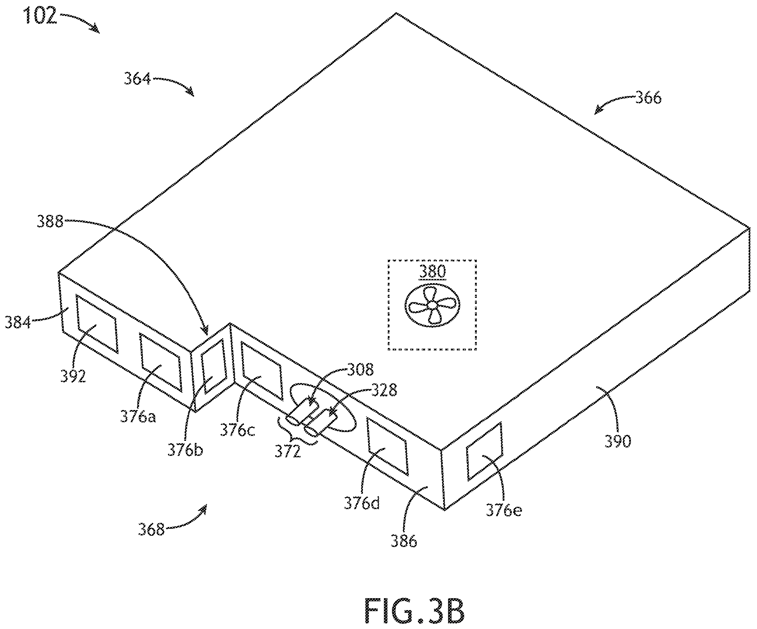

Referring to FIG. 3B, a perspective view of an uninterruptible power supply (UPS) 102, in accordance with one or more examples of the present disclosure is shown. The UPS 102 may have a housing 364 that includes a front side 366 (e.g., a side typically devoid of connectors that would face a user when opening a server cabinet) and an interface surface 368 that provides a surface area configured for coupling to the MBC 204. The interface surface 368 may include a bypass interface 372 configured for mechanically and/or electrically coupling to the MBC 204. For example, the bypass interface 372 may include the second electrical connector 308 of the first connector pair 306 and/or the second electrical connector 332 of the fourth connector pair 330. For mechanically coupling to the MBC 204, the bypass interface 372 may be compatible with any connection technology as detailed for the MBC 204. For example, the end 360 of the MBC 204 may be biased against the bypass interface 372 via a nut-and-bolt connector or internally threaded rod coupling.

The interface surface 368 may configured as a non-flat surface, and may be contoured in a manner to increase the surface area for implementing one or more air vents 376a-d and or creating open spaces 350 when coupled to the MBC 204. Air flow is increased via an internal fan 380. The interface surface 368 may be configured with any type of non-flat topography including but not limited to a staggered-plane topography having a non-recessed surface 384 and a recessed surface 386 approximately parallel with the non-recessed surface 384, and a transverse surface 388 connecting the non-recessed surface and the recessed surface. One or more, or all, surfaces of the UPS 102 may be configured with one or more air vents 376a. For example, and as shown in FIG. 3B, the non-recessed surface may include air vent 376a, the recessed surface 386 may include air vents 376c-d, the transverse surface 388 may include air vent 376b, and a side wall 390 of the UPS 102 may include an air vent 376e. In this manner, the UPS 102 may be configured with sets of air vents 376 that are arranged in different directions, angles, and planes. For example, air vents 376a,c,d are disposed in a different plane, angle, or direction than air vents 376b,e. The UPS 102 may further include one or more connectivity hubs 392 on the interface surface 368 configured for data connectivity and other functions. For example, the connectivity hub 392 may include USB ports, Ethernet ports, I/O ports, breakers, and terminal blocks.

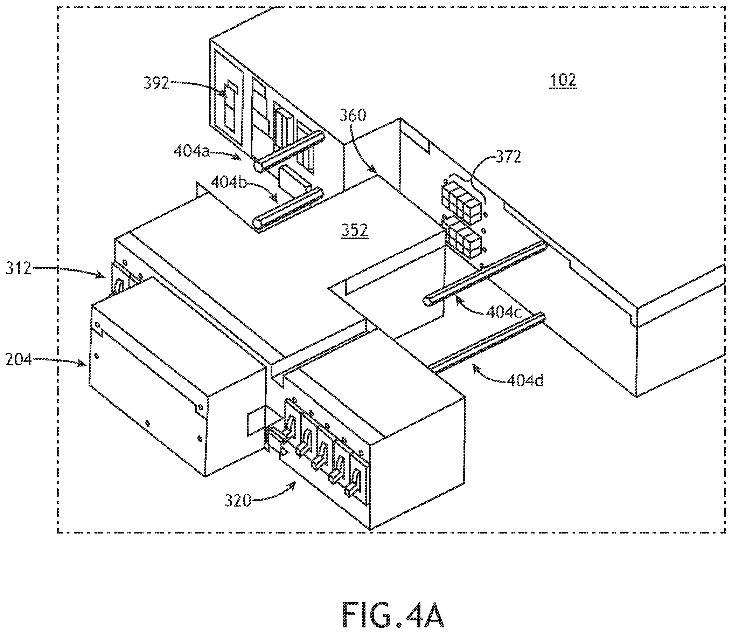

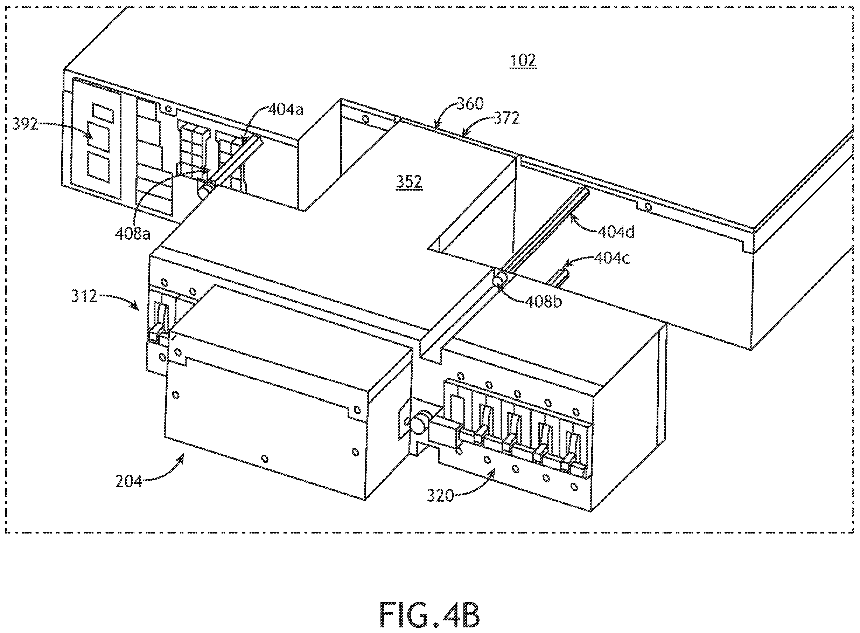

Referring to FIG. 4A, a diagram illustrating the maintenance bypass cabinet (MBC) 204 in a near-coupled position with the uninterruptible power supply (UPS) 102, in accordance with one or more examples of the present disclosure is shown. In some examples, rod couplings 404a-d are used to connect the MBC 204 to the UPS 102. The cantilever portion 352 of the MBC 204 may be arranged so that the end 360 physically interacts with the bypass interface 372 of UPS 102. The MBC 204 is shown coupled to the UPS 102 in FIG. 4B. A stable coupling between the MBC 204 and the UPS 102 may be implemented by tightening screws 408a-b within the rod couplings 404a,d. The physical coupling between the MBC 204 and the UPS 102 also secures the physical and electrical coupling of the first electrical connector 304 with the second electrical connector 308 of the first connector pair 306 and the first electrical connector 328 and the second electrical connector 332 of the fourth connector pair 330. For example, the first connector pair 306 and/or the fourth connector pair 330 may use interference fit electrical connectors that lock into place when the MBC 204 is secured to the UPS 102.

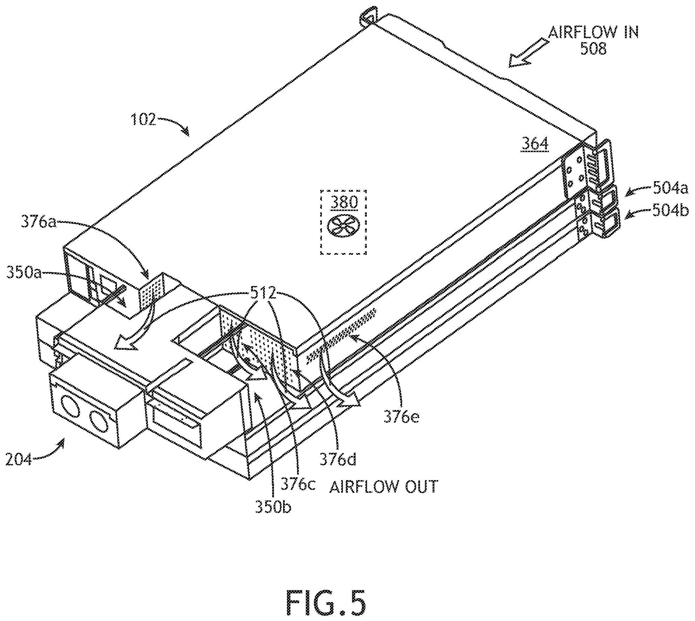

Referring to FIG. 5, a diagram illustrating the maintenance bypass cabinet (MBC) coupled with the uninterruptible power supply (UPS) including predicted airflow patterns, in accordance with one or more examples of the present disclosure is shown. The UPS 102 may include two ancillary modules 504a-b providing circuitry and/or battery support for the UPS 102. Ancillary modules 504a-b such as those shown are commonly attached to the UPS 102 and may produce heat or reduce cooling efficiency, increasing the need for increased air circulation. An internal fan 380 drives incoming air 508 through the housing 364 via one or more vents or vented areas, and output air 512 is released from air vents 376 b-e. The open spaces 350a-b created by the arrangement of the interface surface 368 of the UPS 102 with the cantilever portion 352 of the MBC 204 may greatly increase the ability of the internal fan 380 to remove hot air away from the UPS 102. It is contemplated that the output air 512 may exit the back or side of the UPS 102 and then past the MBC 204 and out of the rack in which the UPS 102 and MBC 204 may be mounted. It is contemplated that the size of the air space 350a, 350b may depend upon the width of the MBC 204. For example, a narrower MBC 204 may allow the space between the UPS 102 and the MBC 204 to be reduced.

The arrangement of the interface surface 368 of the UPS 102 with the cantilever portion 352 of the MBC 204 to remove hot air away from the UPS 102 allows for the design of more compact UPS systems 116 (handling more electrical power per unit volume). Specifically, the arrangement allows for UPS designs with a connected MBC that is within the same U space as the UPS, presenting a thinner design, having a decreased height. For example, a UPS 102 and MBC 204 that was originally designed with a 6-unit (e.g., "U") height may now be designed with a height of 3U. One "U" corresponds to a server unit height of 1.75 inches. In another example, a UPS 102 and MBC 204 originally designed with a 10U height may now be designed as a 4U height. This may represent a two to three times decrease in height requirements which may save 2U to 6U rack space per rack, increasing the space available for other equipment to be stationed on a rack, such as one or more computer servers.

Electronic devices often have strict design requirements that require internal fans 380 to be placed immediately adjacent to an air vent 376. This placement of the internal fan 380 often prevents or limits the design of internal componentry. However, the arrangement of the interface surface 368 with the cantilever portion 352 to remove hot air away from the UPS 102 reduces the burden on the internal fan 380 to cool the UPS 102, permitting placement of the internal air fan 380 away from the air vents 376a-e, and loosening design restrictions.

The UPS 102 included within the UPS system 116 may be configured with any size of power requirements. For example, the UPS 102 may be configured to operate between 5-10 kilovolt amperes (KVA). In another example, the UPS 102 may be configured to operate between 0.5-3 (KVA). In another example, the UPS 102 may be configured to operate between 3-20 (KVA). In another example, the UPS 102 may be configured to operate between 5-10 (KVA). In another example, the UPS 102 may be configured to operate between 0.75 to 5 (KVA). In another example, the UPS 102 may be configured to operate between 1.5-10 (KVA).

As described above, the electrical couplings or connectors of the UPS 102 and the MBC 204 may be of any type or form. For example, the first electric connector 312 of the second connector pair 314, and the first electric connector 320 of the third connector pair 322 may be configured as wire connections that are hard-wired to the complementary second electric connectors 316, 324. By hard wiring the electrical connections between the MBC 204 and the main power supply 104 and/or load 112, space is saved on the bypass connection panel 356. The saved space may allow the addition of multiple first electric connectors 320 to load 112 to be placed on the bypass connection panel 356. The saved space may also allow the bypass connection panel 356 to be reduced in size, which may further increase the size of the open spaces 350a, b, further increasing the cooling ability/efficiency of the internal fan 380. In some examples, the MBC 204 may be configured with power receptacles/outlets (e.g., L5-15R or L5-30R).

The UPS 102 may include any type of battery backup system or battery backup technology. For example, the UPS 102 may include wet acid battery technology. For instance, the UPS 102 may include valve regulated lead acid (VRLA) battery technology. In another example, the UPS 102 may include dry battery technology. For instance, the UPS 102 may include lithium battery technology. In another instance, the UPS 102 may include lithium battery technology and be configured to operate between 5-10 KVA. The UPS system 116 may also include an external battery cabinet configured to store the batteries 108.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable" to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the scope of the subject matter described herein. Furthermore, it is to be understood that the invention is defined by the appended claims.

## Claims

1. A maintenance bypass cabinet configured to switch electrical power between an uninterruptible power supply and a load, comprising:
a cantilevered housing comprising:
a cantilever portion (352) comprising:
an end (360) in proximity to a bypass interface of an uninterruptible power supply; and
a first electrical connector of a first connector pair disposed on the end and electrically couplable to the uninterruptible power supply;
a bypass connection panel mechanically coupled to the cantilever portion and electrically coupled to the first electrical connector, comprising:
a first electrical connector of a second connector pair configured to couple to a main power supply;
a first electrical connector of a third connector pair configured to electrically couple to the load; and
a switch electrically couplable to the first electrical connector of the second connector pair and configured to switch power flow between the first electrical connector of the first connector pair and the first electrical connector of the third connector pair, wherein the cantilever portion is cantilevered off of an interface surface of the uninterruptible power supply, when the maintenance bypass cabinet is coupled to the uninterruptible power supply, to form an open space between the interface surface and the bypass connection panel;
the maintenance bypass cabinet further comprising:
at least two rod couplings, the at least two rod couplings on either side or at least one of the at least two rod coupling on each side of two opposing side surfaces of the cantilever portion, each rod coupling configured to mechanically connect with a respective one of at least two rods (404a-d) extending from the uninterruptible power supply, and the at least two rods being parallel to the two opposing side surfaces of the cantilever portion (352).

2. The maintenance bypass cabinet as claimed in claim 1, wherein the rod couplings are coupled to the bypass connection panel of the cantilevered housing.

3. The maintenance bypass cabinet as claimed in claim 1, wherein the cantilevered housing includes a T shape.

4. The maintenance bypass cabinet as claimed in claim 1, wherein the cantilevered housing includes one or more power receptacles or outlets.

5. An uninterruptible power supply system comprising:
an uninterruptible power supply (102) electrically couplable to a load, configured to power the load and configured to switch the electrical supply of the load to either a main power supply or to a backup power supply, comprising:
a first electrical connector of a first connector pair electrically couplable to the load;
an internal fan configured to cool the uninterruptible power supply; and
an uninterruptible power supply housing comprising an interface surface, the interface surface comprising:
one or more air vents; and
a bypass interface (372) electrically couplable to a cantilever portion (352) of a maintenance bypass cabinet (204), wherein the cantilever portion is cantilevered off of the interface surface of the uninterruptible power supply to form an open space between the interface surface and a bypass connection panel (356) of the maintenance bypass cabinet, when the uninterruptible power supply is coupled to the maintenance bypass cabinet,
the bypass interface comprising a
first electrical connector of a second connector pair configured to electrically couple to a second electrical connector of the second connector pair of the cantilever portion; wherein
the backup power supply comprises a battery electrically coupled to the uninterruptible power supply; the uninterruptible power supply system further comprising
at least two rods (404a-d) extending from the uninterruptible power supply housing, one on each side of two opposing side surfaces of the bypass interface, each rod is configured to mechanically connect with a respective one of at least two rod couplings disposed on either side of two opposing side surfaces of the cantilever portion of the maintenance bypass cabinet.

6. The uninterruptible power supply system of claim 5, wherein the interface surface includes a recessed surface and a non-recessed surface.

7. The uninterruptible power supply system of claim 5, wherein the interface surface includes two or more air vents aligned at different planes.

8. An electrical power system, comprising:
the uninterruptible power supply system of any one of claims 5-7; and
the maintenance bypass cabinet of any one of claims 1-4, wherein the maintenance bypass cabinet is configured to be electrically and mechanically coupled to the uninterruptible power supply and within a same U space as the uninterruptible power supply.

## Patentansprüche

1. Wartungs-Bypass-Schrank, dazu ausgelegt, elektrischen Strom zwischen einer unterbrechungsfreien Stromversorgung und einer Last umzuschalten, umfassend:
ein auskragendes Gehäuse, umfassend:
einen auskragenden Abschnitt (352), umfassend:
ein Ende (360) in der Nähe einer Bypass-Schnittstelle einer unterbrechungsfreien Stromversorgung; und
einen ersten elektrischen Verbinder eines ersten Verbinderpaars, der an dem Ende angeordnet und elektrisch mit der unterbrechungsfreien Stromversorgung koppelbar ist;
ein Bypass-Anschlussfeld, das mechanisch mit dem auskragenden Abschnitt gekoppelt ist und elektrisch mit dem ersten elektrischen Verbinder gekoppelt ist, umfassend:
einen ersten elektrischen Verbinder eines zweiten Verbinderpaars, dazu ausgelegt, mit einer Hauptstromversorgung gekoppelt zu werden;
einen ersten elektrischen Verbinder eines dritten Verbinderpaars, der dazu ausgelegt ist, elektrisch mit der Last gekoppelt zu werden; und
einen Schalter, der elektrisch mit dem ersten elektrischen Verbinder des zweiten Verbinderpaares koppelbar ist und dazu ausgelegt ist, den Stromfluss zwischen dem ersten elektrischen Verbinder des ersten Verbinderpaares und dem ersten elektrischen Verbinder des dritten Verbinderpaares zu schalten, wobei der auskragende Abschnitt von einer Schnittstellenoberfläche der unterbrechungsfreien Stromversorgung auskragt, wenn der Wartungs-Bypass-Schrank mit der unterbrechungsfreien Stromversorgung gekoppelt ist, um einen offenen Raum zwischen der Schnittstellenoberfläche und dem Bypass-Anschlussfeld auszubilden;
der Wartungs-Bypass-Schrank ferner umfassend:
mindestens zwei Stabverbinder, wobei die mindestens zwei Stabverbinder auf jeder Seite liegen oder mindestens einer der mindestens zwei Stabverbinder auf jeder Seite von zwei gegenüberliegenden Seitenflächen des auskragenden Abschnitts liegt,
wobei jeder Stabverbinder dazu ausgelegt ist, mechanisch mit einem jeweiligen von mindestens zwei Stäben (404a-d) verbunden zu werden, die sich von der unterbrechungsfreien Stromversorgung aus erstrecken, und wobei die mindestens zwei Stäbe parallel zu den zwei gegenüberliegenden Seitenflächen des auskragenden Abschnitts (352) liegen.

2. Wartungs-Bypass-Schrank nach Anspruch 1, wobei die Stabverbinder mit dem Bypass-Anschlussfeld des auskragenden Gehäuses gekoppelt sind.

3. Wartungs-Bypass-Schrank nach Anspruch 1, wobei das auskragende Gehäuse eine T-Form aufweist.

4. Wartungs-Bypass-Schrank nach Anspruch 1, wobei das auskragende Gehäuse einen oder mehrere Stromanschlüsse oder -ausgänge beinhaltet.

5. Unterbrechungsfreies Stromversorgungssystem, umfassend:
eine unterbrechungsfreie Stromversorgung (102), die elektrisch mit einer Last koppelbar ist, dazu ausgelegt, die Last mit Strom zu versorgen, und dazu ausgelegt, die elektrische Versorgung der Last entweder auf eine Hauptstromversorgung oder auf eine Ersatzstromversorgung umzuschalten, umfassend:
einen ersten elektrischen Verbinder eines ersten Verbinderpaares, der elektrisch mit der Last koppelbar ist;
einen internen Lüfter, dazu ausgelegt, die unterbrechungsfreie Stromversorgung zu kühlen; und
ein Gehäuse der unterbrechungsfreien Stromversorgung, umfassend eine Schnittstellenoberfläche, die Schnittstellenoberfläche umfassend:
einen oder mehrere Luftauslässe; und
eine Bypass-Schnittstelle (372), die elektrisch mit einem auskragenden Abschnitt (352) eines Wartungs-Bypass-Schranks (204) koppelbar ist, wobei der auskragende Abschnitt von der Schnittstellenoberfläche der unterbrechungsfreien Stromversorgung auskragend angeordnet ist, um einen offenen Raum zwischen der Schnittstellenoberfläche und einem Bypass-Anschlussfeld (356) des Wartungs-Bypass-Schranks auszubilden, wenn die unterbrechungsfreie Stromversorgung mit dem Wartungs-Bypass-Schrank gekoppelt ist, die Bypass-Schnittstelle umfassend einen ersten elektrischen Verbinder eines zweiten Verbinderpaars, der dazu ausgelegt ist, elektrisch mit einem zweiten elektrischen Verbinder des zweiten Verbinderpaars des auskragenden Abschnitts zu koppeln; wobei
die Ersatzstromversorgung eine Batterie umfasst, die elektrisch mit der unterbrechungsfreien Stromversorgung gekoppelt ist; das unterbrechungsfreie Stromversorgungssystem ferner umfassend mindestens zwei Stäbe (404a-d), die sich von dem Gehäuse der unterbrechungsfreien Stromversorgung aus erstrecken, eine auf jeder Seite von zwei gegenüberliegenden Seitenflächen der Bypass-Schnittstelle, wobei jeder Stab dazu ausgelegt ist, mechanisch mit einem jeweiligen von mindestens zwei Stabverbindern verbunden zu werden, die auf jeder Seite von zwei gegenüberliegenden Seitenflächen des auskragenden Abschnitts des Wartungs-Bypass-Schranks angeordnet sind.

6. Unterbrechungsfreies Stromversorgungssystem nach Anspruch 5, wobei die Schnittstellenoberfläche eine vertiefte Oberfläche und eine nicht vertiefte Oberfläche beinhaltet.

7. Unterbrechungsfreies Stromversorgungssystem nach Anspruch 5, wobei die Schnittstellenoberfläche zwei oder mehr Luftauslässe beinhaltet, die in verschiedenen Ebenen ausgerichtet sind.

8. Elektrisches Stromsystem, umfassend:
das unterbrechungsfreie Stromversorgungssystem nach einem der Ansprüche 5-7; und
den Wartungs-Bypass-Schrank nach einem der Ansprüche 1-4, wobei der Wartungs-Bypass-Schrank dazu ausgelegt ist, elektrisch und mechanisch mit der unterbrechungsfreien Stromversorgung und innerhalb desselben U-Raums wie die unterbrechungsfreie Stromversorgung gekoppelt zu sein.

## Revendications

1. Armoire de dérivation de maintenance configurée pour commuter une puissance électrique entre une alimentation sans interruption et une charge, comprenant :
un boîtier en porte-à-faux comprenant :
une partie en porte-à-faux (352) comprenant :
une extrémité (360) à proximité d'une interface de dérivation d'une alimentation sans interruption ; et
un premier connecteur électrique d'une première paire de connecteurs disposé sur l'extrémité et pouvant être couplé électriquement à l'alimentation sans interruption ;
un panneau de connexion de dérivation couplé mécaniquement à la partie en porte-à-faux et couplé électriquement au premier connecteur électrique, comprenant :
un premier connecteur électrique d'une deuxième paire de connecteurs configuré pour être couplé à une alimentation principale ;
un premier connecteur électrique d'une troisième paire de connecteurs configuré pour être couplé électriquement à la charge ; et
un commutateur pouvant être couplé électriquement au premier connecteur électrique de la deuxième paire de connecteurs et configuré pour commuter un flux de puissance entre le premier connecteur électrique de la première paire de connecteurs et le premier connecteur électrique de la troisième paire de connecteurs, la partie en porte-à-faux étant en porte-à-faux à partir d'une surface d'interface de l'alimentation sans interruption, lorsque l'armoire de dérivation de maintenance est couplée à l'alimentation sans interruption, de manière à former un espace ouvert entre la surface d'interface et le panneau de connexion de dérivation ;
l'armoire de dérivation de maintenance comprenant en outre :
au moins deux accouplements de tige, les au moins deux accouplements de tige étant situés de part et d'autre, ou au moins l'un des au moins deux accouplements de tige étant situé de chaque côté de deux surfaces latérales opposées de la partie en porte-à-faux,
chaque accouplement de tige étant configuré pour être connecté mécaniquement à une tige respective parmi au moins deux tiges (404a-d) s'étendant depuis l'alimentation sans interruption, et les au moins deux tiges étant parallèles aux deux surfaces latérales opposées de la partie en porte-à-faux (352).

2. Armoire de dérivation de maintenance selon la revendication 1, dans laquelle les accouplements de tige sont couplés au panneau de connexion de dérivation du boîtier en porte-à-faux.

3. Armoire de dérivation de maintenance selon la revendication 1, dans laquelle le boîtier en porte-à-faux présente une forme en T.

4. Armoire de dérivation de maintenance selon la revendication 1, dans laquelle le boîtier en porte-à-faux comporte un ou plusieurs socles de prise de courant ou une ou plusieurs prises de courant.

5. Système d'alimentation sans interruption comprenant :
une alimentation sans interruption (102) pouvant être couplée électriquement à une charge, configurée pour alimenter la charge et configurée pour commuter l'alimentation électrique de la charge soit vers une alimentation principale, soit vers une alimentation de secours, comprenant :
un premier connecteur électrique d'une première paire de connecteurs pouvant être couplé électriquement à la charge ;
un ventilateur interne configuré pour refroidir l'alimentation sans interruption ; et
un boîtier d'alimentation sans interruption comprenant une surface d'interface, la surface d'interface comprenant :
une ou plusieurs ouvertures de ventilation ; et
une interface de dérivation (372) pouvant être couplée électriquement à une partie en porte-à-faux (352) d'une armoire de dérivation de maintenance (204), la partie en porte-à-faux étant en porte-à-faux à partir de la surface d'interface de l'alimentation sans interruption de manière à former un espace ouvert entre la surface d'interface et un panneau de connexion de dérivation (356) de l'armoire de dérivation de maintenance, lorsque l'alimentation sans interruption est couplée à l'armoire de dérivation de maintenance, l'interface de dérivation comprenant un premier connecteur électrique d'une deuxième paire de connecteurs configuré pour être couplé électriquement à un deuxième connecteur électrique de la deuxième paire de connecteurs de la partie en porte-à-faux ; dans lequel
l'alimentation de secours comprend une batterie couplée électriquement à l'alimentation sans interruption ; le système d'alimentation sans interruption comprenant en outre au moins deux tiges (404a-d) s'étendant depuis le boîtier d'alimentation sans interruption, une de chaque côté de deux surfaces latérales opposées de l'interface de dérivation, chaque tige est configurée pour être connectée mécaniquement à un accouplement de tige respectif parmi au moins deux accouplements de tige disposés de part et d'autre de deux surfaces latérales opposées de la partie en porte-à-faux de l'armoire de dérivation de maintenance.

6. Système d'alimentation sans interruption selon la revendication 5, dans lequel la surface d'interface comporte une surface en retrait et une surface non en retrait.

7. Système d'alimentation sans interruption selon la revendication 5, dans lequel la surface d'interface comporte au moins deux ouvertures de ventilation alignées dans des plans différents.

8. Système d'alimentation électrique, comprenant :
le système d'alimentation sans interruption selon l'une quelconque des revendications 5 à 7 ; et
l'armoire de dérivation de maintenance selon l'une quelconque des revendications 1 à 4, l'armoire de dérivation de maintenance étant configurée pour être couplée électriquement et mécaniquement à l'alimentation sans interruption et se trouver dans un même espace U que l'alimentation sans interruption.
